# EUROPEAN PATENT APPLICATION

(11) **EP 4 697 882 A1**
(43) Date of publication of application: **18.02.2026**
(21) Application number: 25194986.3
(22) Date of filing: 08.08.2025
(51) Int. Cl.: H05K 7/20

(54) **COOLING AIRFLOW SYSTEMS FOR DATA CENTRES**

(30) Priority: 16.08.2024 US 202463683983 P; 06.08.2025 US 202519292161
(71) Applicant: Vertiv Corporation, Westerville, OH 43082 (US)
(72) Inventor: MOSCHENI, Andrea, Westerville, 43082 (US)
(74) Representative: Bryn-Jacobsen, Caelia

(57) **Abstract**

A data center cooling system includes a first interior space for containing electronic equipment, a second interior space for containing at least one fan, and a third interior space for containing at least one cooling unit. The first interior space is thermally separated from the second and third interior spaces such that hot air is drawn from the first interior space, conditioned, and then the cold air is delivered into the first interior space again. The at least one fan is positioned overhead of the electronic equipment, for instance in the ceiling, to improve the air distribution and increase the maximum airflow. The at least one cooling unit is positioned to at least one side of the first interior space. In use, the at least one fan and the at least one cooling unit operate together to condition and recirculate air through interior spaces.

## Description

### CROSS REFERENCE TO RELATED APPLICATION

The present application claims priority to U.S. Provisional Patent Application No. 63/683,983, filed August 16, 2024, and U.S. Non-Provisional Patent Application No. 19/292,161, filed on August 6, 2025.

### TECHNICAL FIELD

The present disclosure is directed generally to cooling solutions for data centers and other controlled-temperature environments, and more particularly, to cooling schemes that utilize separate and strategically positioned cooling units/coils and fans to increase air flow and distribution while maximizing room space for installing electronic equipment.

### BACKGROUND

Data centers are facilities for housing electronic equipment such as servers, networking devices, storage devices, power supplies, and associated cables. Within a data center, electronic equipment is typically mounted to racks, and racks are typically arranged to form rows and aisles for organizing and facilitating access to the electronic equipment. Data centers may be small-scale such as prefabricated and portable, large-scale and permanent, and hyper-scale depending on the amount of electronic equipment and data being processed.

Electronic equipment consumes electrical energy, and thus the larger the data center the more energy that is consumed. Advances in computing technology and connectors have made possible extremely high-density applications. An undesirable byproduct of electronic equipment usage is heat, which can degrade the performance of the equipment and cause equipment failure. As such, cooling solutions have been developed to manage heat production in data centers.

Traditional cooling solutions for high-density applications utilize in-row or rear door heat exchangers installed adjacent to the rack servers. While effective in some applications, heat exchangers require an extensive network of supply and return coolant pipes, consume valuable floor space in the data center, constrain rack and aisle positions, and introduce the potential for coolant leakage harmful to electronic equipment.

Other traditional cooling solutions for data centers utilize integrated units having both coils and fans, and which are installed around the room perimeter. While effective in some applications, these units suffer from airflow distribution challenges considering their installation location at the edges of the room and at distance from some of the electronic equipment.

Therefore, what is needed is a cooling solution that overcomes the disadvantages of the prior art, and which is adaptable for use with various data center configurations, positionings the air handling components out of the valuable data center floor space, and eliminates the possibility of coolant leakage near the electronic equipment.

### SUMMARY

According to a first aspect, the present disclosure is directed to a data center including a first interior space for containing electronic equipment, a second interior space positioned above the first interior space and containing or supporting at least one fan, and a third interior space positioned to a lateral side of the first interior space and containing at least one cooling unit/coil. A first thermal separator/barrier is positioned between the first interior space and the second interior space. A second physical separator/thermal barrier is positioned between the third interior space and the first interior space. In use, at least one fan is operable to draw hot air from the first interior space into the second interior space across the first thermal barrier, the second interior space and the third interior space are fluidly coupled such that the hot air flows from the second interior space into the third interior space, and the at least one cooling unit/coil is operable to condition the hot air in the third interior space to cold air and deliver the cold air into the first interior space across the second thermal barrier.

In some examples, the at least one fan and the at least one cooling unit/coil are configured to recirculate air through the first, second, and third interior spaces, in sequence.

In some examples, the first thermal barrier is a ceiling or a containment separator, the at least one fan is mounted in the ceiling, the second thermal barrier is a wall, and the at least one cooling unit/coil is positioned adjacent to the wall.

In some examples, the data center further includes at least one sensor positioned in at least one of the first interior space or second interior space configured to sense at least one of air temperature, or pressure, and a controller communicatively coupled to the at least one fan and to the at least one sensor. The controller includes processing circuitry configured to receive outputs from the at least one sensor and independently control the at least one fan based on the received outputs from the at least one sensor.

In some examples, the controller is further communicatively coupled to the at least one cooling unit/coil, and the processing circuitry is further configured to control the at least one cooling unit based on the received inputs from the at least one sensor.

In some examples, the at least one fan includes a plurality of fans forming at least one row of fans for positioning overhead at least one row/aisle of electronic equipment contained in the first interior space.

In some example, the data center further includes at least one row of racks for mounting electronic equipment positioned in the first interior space, and at least one aisle positioned adjacent to the at least one row of racks, wherein the at least one fan is positioned above the at least one row of racks and is configured to draw the hot air from above the at least one row of racks, and the at least one cooling unit/coil is configured to direct the cold air toward the at least one aisle.

According to another aspect, the present disclosure is directed to a data center including a first interior space for containing electronic equipment, a second interior space positioned to a lateral side of the first interior space and containing at least one cooling unit/coil, and a third interior space positioned above the first interior space and containing/supporting at least one fan. A first thermal separator/barrier is positioned between the first interior space and the second interior space. A second thermal separator/barrier is positioned between the third interior space and the first interior space. In use, the at least one cooling unit/coil is operable to draw hot air from the first interior space into the second interior space across the first thermal barrier, condition the hot air to cold air, the second interior space and the third interior space are fluidly coupled such that the cold air flows from the second interior space into the third interior space, and the at least one fan is operable to deliver the cold air from the third interior space into the first interior space across the second thermal barrier.

According to a further aspect, the present disclosure is directed to a system for conditioning and recirculating air in a data center including electronic equipment positioned in an interior space. In examples, the system includes a first plenum positionable above the interior space and containing at least one fan, a second plenum positionable to a lateral side of the interior space and containing at least one cooling unit/coil, at least one sensor positionable in the interior space configured to sense at least one of air temperature and pressure in the interior space, and a controller communicatively coupled to the at least one fan, to the at least one sensor, and to the at least one cooling unit. In examples, the controller includes processing circuitry configured to receive outputs from the at least one sensor, independently control the at least one fan based on the received outputs from the at least one sensor, and independently control the at least one cooling unit based on the received outputs from the at least one sensor.

In some examples, the controller is configured to operate the at least one fan to draw hot air from the interior space into the first plenum, operate the at least one cooling unit to condition the hot air in the second plenum to cold air, and operate the at least one cooling unit to deliver the cold air into the interior space.

In some examples, the at least one fan is positionable to draw hot air from above at least one rack of the electronic equipment, and the at least one cooling unit is configured to direct the cold air to at least one aisle positioned adjacent to the at least one rack of electronic equipment.

In some examples, the controller is configured to operate the at least one cooling unit to draw hot air from interior space, condition the hot air to cold air, and deliver the cold air into the second plenum, and operate the at least one fan to deliver the cold air in the first plenum to the interior space.

In some examples, the at least one cooling unit is configured to draw hot air from an aisle in the interior space, and the at least one fan is configured to direct the cold air toward at least one rack of electronic equipment positioned adjacent to the at least one aisle.

In some examples, the first plenum and the second plenum are thermally separated from the interior space.

This summary is provided solely as an introduction to subject matter that is fully described in the following detailed description and drawing figures. This summary should not be considered to describe essential features nor be used to determine the scope of the claims. Moreover, it is to be understood that both the foregoing summary and the following detailed description are explanatory only and are not necessarily restrictive of the subject matter claimed.

### BRIEF DESCRIPTION OF THE DRAWINGS

Implementations of the present disclosure disclosed herein may be better understood when consideration is given to the following detailed description thereof. Such description refers to the included drawings, which are not necessarily to scale, and in which some features may be exaggerated, and some features may be omitted or may be represented schematically in the interest of clarity. Like reference numerals in the drawings may represent and refer to the same or similar element, feature, or function. In the drawings:
FIG. 1 is a schematic diagram illustrating a data center cooling system according to the present disclosure;
FIG. 2 is a schematic diagram illustrating a first example of the data center cooling system according to the present disclosure;
FIG. 3 is an overhead view of the data center example of FIG. 2 illustrating a first recirculating airflow configuration;
FIG. 4 is an overhead view of the data center of FIG. 2 illustrating a second recirculating airflow configuration;
FIG. 5 is a schematic diagram illustrating a second example of the data center cooling system according to the present disclosure;
FIG. 6 is an overhead view of the data center example of FIG. 5 illustrating a first recirculating airflow configuration; and
FIG. 7 is an overhead view of the data center example of FIG. 5 illustrating a second recirculating airflow configuration.

### DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art having the benefit of the instant disclosure that the examples disclosed herein may be practiced without some of these specific details. In other instances, well-known features may not be described in detail to avoid unnecessarily complicating the instant disclosure.

As used herein a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein any reference to "one example" or "some examples" means that a particular element, feature, structure, or characteristic described in connection with the example is included in at least one example disclosed herein. The appearances of the phrase "in some examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

Broadly speaking, examples of the present disclosure disclosed herein are directed to systems for cooling a volume of air in a data center to manage the heat produced by operating electronic equipment. In examples, separate interior spaces are provided and are thermally separated from other interior spaces. At least some of the interior spaces contain equipment for flowing and/or conditioning air. The interior spaces and the contained equipment are configured such that a recirculating airflow is created to draw hot air away from the electronic equipment and return cold air to the electronic equipment by flowing air through the interior spaces in sequence. In some examples, at least one fan is positioned in overhead relation to the electronic equipment such that air is moved through the ceiling, and at least one cooling unit is positioned in lateral relation to the electronic equipment such that air is further moved through at least one wall.

Benefits and advantages of the examples disclosed herein include, but are not limited to, an increased amount of recirculating air in a data center environment considering the use of multiple fans for each row, and a more homogenous air temperature distribution (e.g., reduction in hot spots) considering fan proximity to the racks and independent fan controllability. In addition, benefits include greater flexibility in positioning electronic equipment, increased equipment density, and fewer coolant supply and delivery connections as compared to traditional cooling systems.

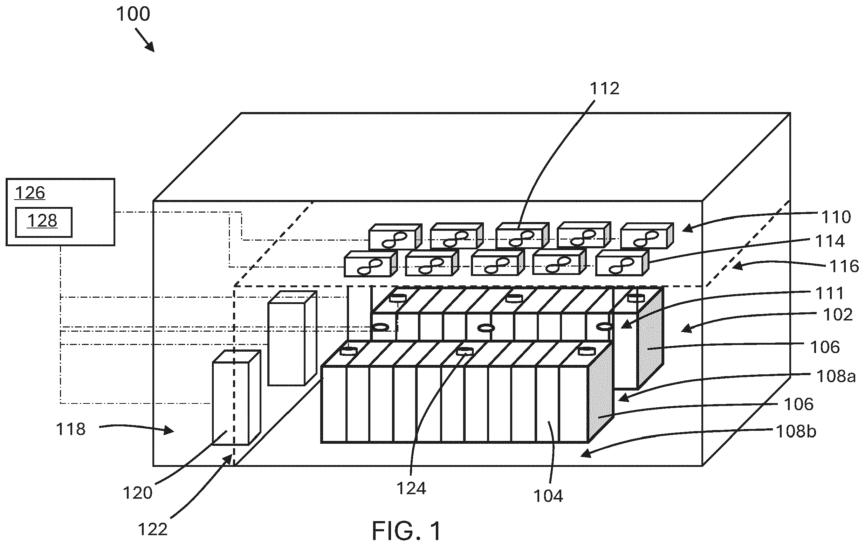

FIG. 1 is a schematic diagram illustrating a data center cooling system 100 according to the present disclosure. The system generally includes compartmentalized and thermally separated interior spaces containing different equipment. In examples, a first interior space 102 contains electronic equipment such as computing equipment, storage devices, power supplies, cabling, etc. The electronic equipment may be mounted to racks 104 that are arranged to form rows of racks 106 separated by aisles 108a, 108b for facilitating access to the electronic equipment. Racks may be floor-mounted and extend upward. As shown, the rows of racks 106 and aisles 108a, 108b are oriented parallel to a longitudinal axis of the first interior space 102. The data center may include any number of racks 104, rows of racks 106, aisles 108a, 108b, etc., in various non-limiting configurations. The rows of racks 106 and aisles 108a, 108b as shown in a particular configuration considering the location of the additional interior spaces relative to the first interior space 102.

The system 100 further includes a second interior space 110 positioned above the first interior space 102. In examples, the second interior space 110 may be defined by or positioned in the ceiling, a plenum, a containment separator, etc. The second interior space 110 contains at least one fan 112, and alternatively a plurality of fans 112. The number of fans 112 and positions thereof may correspond to at least one of the number of rows of racks 106, dimensions of the rows of racks 106, etc. As shown, a plurality of fans 112 are positioned to form a row of fans 114, wherein each row of fans 112 corresponds and aligns relative to one of the rows of racks 106 as discussed further below. A containment strategy 111 may be applied to physically separate the hot and cold air inside the space 102 to prevent their mixing to ensure an optimal performance of the electronic equipment. For instance, there may be two types of containment systems that include different aisle arrangements, i.e., a hot aisle containment 108a and a cold aisle containment 108b. The hot aisle containment may include enclosing the hot aisles, where the hot air exhausts from the servers, and the cold air containment may include enclosing the cold aisles, where the cool air is supplied to the servers.

The first interior space 102 is configured to contain a first volume of air. As described above, the system 100 may apply a containment strategy to prevent hot and cold air mixing. For explanation and comparative purposes, the volume of air contained in the first interior space 102 and the cold aisle 108b may be considered 'cold' air coming from the cooling unit/coil, and the hot aisle 108a may be 'hot' resulting from the heat generated by the operating electronic equipment contained in the rack 104 of the first interior space 102. The second interior space 110 is configured to contain a second volume of air. A first thermal barrier 116 is positioned between the first and second interior spaces 102, 110 to provide a thermal demarcation between the volumes of air. In examples, the first thermal barrier 116 may be a physical barrier such as a ceiling, false ceiling, plenum wall, etc. The at least one fan 112 may be mounted to the first thermal barrier 116, for instance mounted in the ceiling. In use, the at least one fan 112 is operative to move air across the first thermal barrier 116, for example, to draw hot air from the first interior space 102 into the second interior space 110.

The system 100 further includes a third interior space 118 positioned to at least one lateral side of the first interior space 102. As shown, the third interior space 118 is implemented as a column positioned to a single lateral side of the first interior space 102. The third interior space 118 is configured to contain at least one cooling unit 120 or also known as a coiling coil or heat exchanger, operative to condition air. The third interior space 118 contains a third volume of air thermally separated from the first volume of air by a second thermal barrier 122 which is positioned between the third interior space 118 and the first interior space 102. In examples, the second thermal barrier 122 may be a physical barrier such as a wall, casing of the at least one cooling unit 118, combinations thereof, etc. In use, the at least one cooling unit 120 is operative to condition hot air drawn into the cooling unit into 'cold' air, for example air from within the third interior space 118, and deliver the cold air to, for example, the first interior space 102. Particular airflow configurations are described further below.

The system 100 further includes at least one sensor 124 for sensing a condition in the data center. In examples, the at least one sensor 124 is positioned in the first interior space 102 and in relation to the at least one row of racks 106. In an exemplary example, the at least one sensor 124 includes a plurality of sensors positioned to form a row of sensors, wherein each row of sensors corresponds to at least one of a row of racks 106 or predefined portion of the first interior space 102. For example, the at least one sensor 124 may be mounted to or overhead a row of racks 106 to sense at least one condition pertaining to the environment immediately surrounding the certain electronic equipment. Sensed conditions may include, but are not limited to, air temperature cold and/or hot, and air pressure, and sensor types may include any traditional sensor types for sensing the aforementioned conditions. In examples, the sensors 124 may be networked according to row, predefined area, etc.

The system 100 further includes at least one controller 126 including processing circuitry 128. The at least one controller 126 may be located within the data center, remotely or both. In examples, the at least one controller 126 is communicatively coupled the at least one sensor 124, to the at least one fan 112, and to the at least one cooling unit 120. In use, the processing circuitry 128 is configured to receive output data from the at least one sensor 124, process the received output data, and utilize the processed data to control each of the at least one fan 112 and the at least one cooling unit 120. The at least one cooling unit 120 may employ a sensor to define a supply temperature. In an exemplary example, each of the at least one fan 112 and the at least one cooling unit 120 is independently controllable such that a greater airflow and/or cooling effect can be applied where needed, for example, to avoid hot spots. The at least one controller 126 may be configured to operate the equipment according to a program or on demand.

In some examples, the at least one controller 126 is configured to receive, determine, instruct, execute, etc. The at least one controller 126 may include at least one processor, memory, and a communication interface, wherein the processor provides processing functionality for at least the respective controller and may include any number of processors, micro-controllers, circuitry, field programmable gate array (FPGA) or other processing systems, and resident or external memory for storing data, executable code, and other information accessed or generated by respective controller. The processor may execute one or more software programs embodied in a non-transitory computer readable medium (e.g., memory) that implements techniques described herein. The processor is not limited by the materials from which it is formed, or the processing mechanisms employed therein and, as such, can be implemented via semiconductor(s) and/or transistors (e.g., using electronic integrated circuit (IC) components), and so forth.

The memory may be an example of tangible, computer-readable storage medium that provides storage functionality to store various data and/or program code associated with operation of the processor, such as software programs and/or code segments, or other data to instruct the processor, and possibly other components of the controller, to perform the functionality described herein. Thus, the memory can store data, such as a program of instructions for operating the respective controller, including its components (e.g., processor, communication interface, etc.), and so forth. It should be noted that while a single memory is described, a wide variety of types and combinations of memory (e.g., tangible, non-transitory memory) may be employed. The memory may be integral with the processor, may comprise stand-alone memory, or may be a combination of both. Some examples of the memory may include removable and non-removable memory components, such as random-access memory (RAM), read-only memory (ROM), flash memory (e.g., a secure digital (SD) memory card, a mini-SD memory card, and/or a micro-SD memory card), solid-state drive (SSD) memory, magnetic memory, optical memory, universal serial bus (USB) memory devices, hard disk memory, external memory, and so forth.

The communication interface may be operatively configured to communicate with components of the respective controller. For example, the communication interface may be configured to retrieve data from the processor or other devices, transmit data for storage in the memory, retrieve data from storage in the memory, and so forth. The communication interface may also be communicatively coupled with the processor to facilitate data transfer between components of the respective controller and the processor. It should be noted that while the communication interface is described as a component of the respective controller, one or more components of the communication interface may be implemented as external components communicatively coupled to the respective controller via a wired and/or wireless connection. The respective controller may also include and/or connect to one or more input/output (I/O) devices (e.g., human machine interface (HMI) devices) via the communication interface. In examples, the communication interface may include a transmitter and receiver.

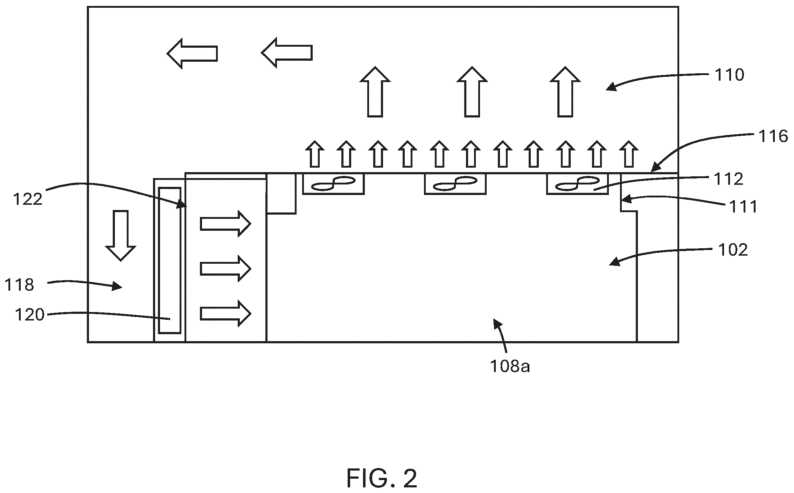

FIG. 2 schematically illustrates a first airflow configuration for the system 100. As shown, the second interior space 110 is positioned above the first interior space 102, and the third interior space 118 is positioned to a lateral side of the first interior space 102. In some examples, the second and third interior spaces 110, 118 may be fluidly coupled, for instance integrally formed, such that air flows freely between the two spaces and by a pressure differential between the two volumes of air. In the configuration shown, the at least one fan 112 is operable to draw hot air from the first interior space 102 in particular from the hot aisle 108a into the second interior space 110 across the first thermal barrier 116, and the at least one cooling unit 120 is operable to condition the hot air in the third interior space 118 to cold air and deliver or reintroduce the cold air into the first interior space 102 across the second thermal barrier 122. As used herein, the terms 'hot' and 'cold' do not denote a particular temperature or temperature range but are used comparatively to define 'hot' as having higher temperature as compared to 'cold.'

The at least one fan 112 and the at least one cooling unit 120 are decoupled and separated such that they cooperate to recirculate air through the first, second, and third interior spaces 102, 110, 118, in sequence. In use, the air draws heat upward away from the first interior space 102 containing the electronic equipment, removes heat outside of the first interior space 102, and reintroduces cold air into the first interior space 102. The at least one fan 112 is positioned above the first interior space 102 to draw hot air upward. The fluid coupling allows the hot air to flow between the second and third interior spaces (110, 118). The hot air in the third interior space (118) in draw into the at least one cooling unit 120 and conditioned to cold air before being reintroduced into the first interior space 102. In a non-limiting example, the at least one cooling unit 120 may be a heat exchanger.

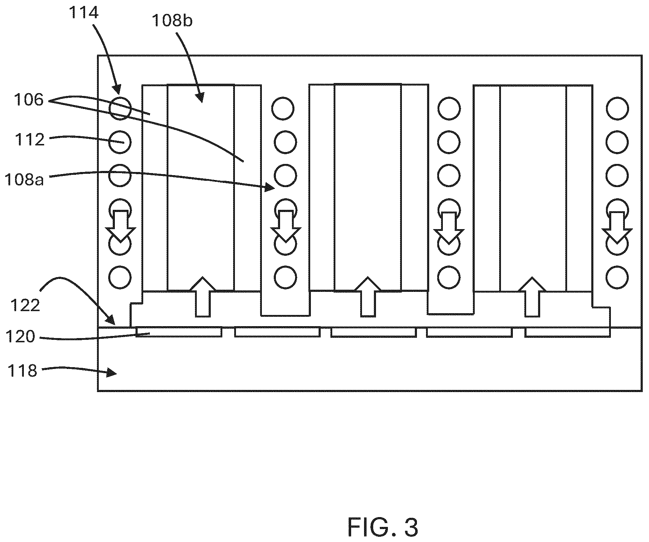

FIG. 3 schematically illustrates a first implementation for the first example of the airflow configuration according to FIG. 2. As shown, the rows of racks 106 and the aisles 108 (e.g., hot aisle 108a and cold aisle 108b) are positioned parallel and with their longitudinal axis aligned with the airflow direction delivered from the third interior space 118. The rows of fans 114 are similarly oriented and positioned laterally shifted relative to their respective rows of racks 106 such that the rows of fans 114 are positioned overhead of the aisles 108. Each cooling unit 120 is positioned longitudinally along the row of racks 106. As the distance away from the at least one cooling unit 120 increases, the controller may operate the at least one fan 112 positioned farther from the at least one cooling unit 120 at a greater speed to move a greater volume of air as compared to the near positioned at least one fan 112.

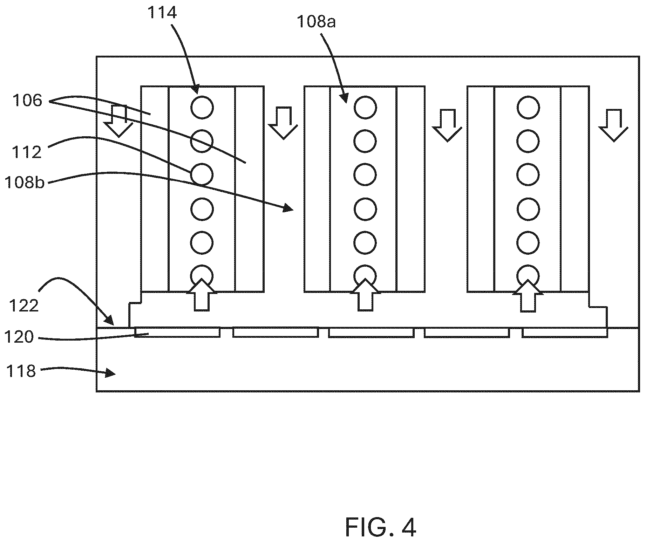

FIG. 4 schematically illustrates a second implementation for the first example of the airflow configuration according to FIG. 2. As shown, the rows of racks 106 and the aisles 108 (e.g., hot aisle 108a and cold aisle 108b) are positioned parallel and with their longitudinal axis aligned with the airflow direction delivered from the third interior space 118. The rows of fans 114 are positioned directly overhead the respective rows of racks 106, and the at least one cooling unit 120 is positioned to direct the cold air toward the rows of racks 106. Each cooling unit 120 is positioned relative to at least one row of racks 106 such that the primary return airflow is longitudinally along the row of racks 106. As the distance away from the at least one cooling unit 120 increases, the controller may operate the at least one fan 112 positioned farther from the at least one cooling unit 120 at a greater speed to move a greater volume of air as compared to the near positioned at least one fan 112.

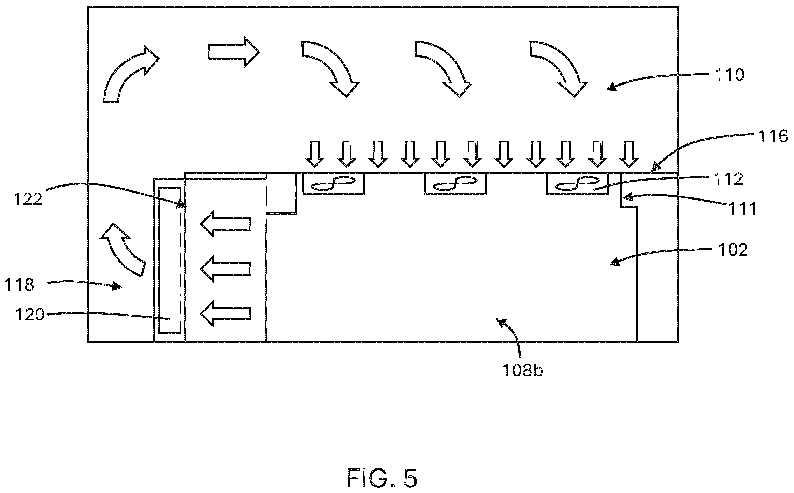

FIG. 5 schematically illustrates a second airflow configuration for the system 100. As shown, the second interior space 110 is positioned above the first interior space 102, and the third interior space 118 is positioned to a lateral side of the first interior space 102. In some examples, the second and third interior spaces 110, 118 may be fluidly coupled, for instance integrally formed, such that air flows freely between the two spaces. In the configuration shown, the at least cooling unit 120 is operable to draw hot air laterally from the first interior space 102 across the second thermal barrier 122. The drawn air is conditioned to remove heat to produce cold air, and the cold air produced is delivered into the third interior space 118. Considering the fluid coupling of the second and third interior spaces 110, 118, the cold air migrates from the third interior space 118 to the second interior space 110 because of the negative pressure created in the second interior space 110 by the operating at least one fan 112. The cold air is then delivered into the first interior space 102, for example, from the hot aisle 108s across the first thermal barrier 116. Again, as used herein, the terms 'hot' and 'cold' do not denote a particular temperature or temperature range but are used comparatively.

Like the above first example, the at least one fan 112 and the at least one cooling unit 120 are decoupled and separated such that they cooperate to recirculate air through the third, second, and first interior spaces 118, 110, 102, in sequence. In use, the air draws heat laterally away from the first interior space 102 containing the electronic equipment, removes heat outside of the first interior space 102, and reintroduces cold air into the first interior space 102 from above. The at least one fan 112 is positioned above the first interior space 102 to direct the cold air downward. In a non-limiting example, the at least one cooling unit 120 may be a heat exchanger.

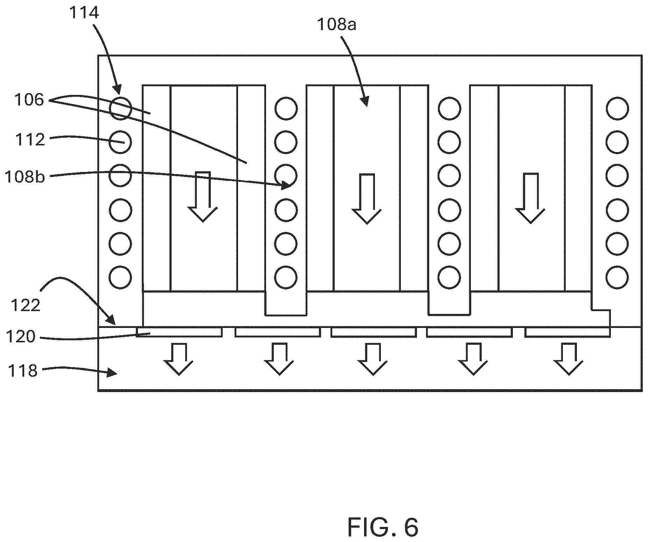

FIG. 6 schematically illustrates a first implementation for the second example of the airflow configuration according to FIG. 5. As shown, the rows of racks 106 and the aisles 108 (e.g., hot aisle 108a and cold aisle 108b) are positioned parallel and with their longitudinal axis aligned with the airflow direction toward the third interior space 118. The rows of fans 114 are similarly oriented and positioned laterally shifted relative to their respective rows of racks 106 such that the rows of fans 114 are positioned overhead of the aisles 108. As the distance away from the at least one cooling unit 120 increases, the controller may operate the at least one fan 112 positioned farther from the at least one cooling unit 120 at a greater speed to move a greater volume of air as compared to the near positioned at least one fan 112.

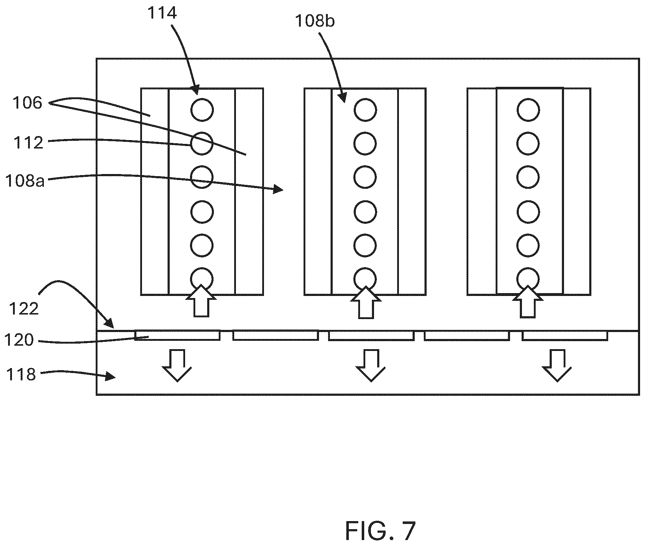

FIG. 7 schematically illustrates a second implementation for the second example of the airflow configuration according to FIG. 5. As shown, the rows of racks 106 and the aisles 108 (e.g., hot aisle 108a and cold aisle 108b) are positioned parallel and with their longitudinal axis aligned with the airflow direction drawn into the third interior space 118. The rows of fans 114 are positioned directly overhead the respective rows of racks 106, and the at least one cooling unit 120 is positioned to draw hot air away from the rows of racks 106. As the distance away from the at least one cooling unit 120 increases, the controller may operate the at least one fan 112 positioned farther from the at least one cooling unit 120 at a greater speed to move a greater volume of air as compared to the near positioned at least one fan 112.

Further examples are set out in the clauses below:
1. A data center comprising:
   a first interior space in which electronic equipment is disposed, the first interior space including at least one hot aisle and at least one cold separated according to a containment strategy;
   a second interior space defined above the first interior space, the second interior space containing at least one fan;
   a third interior space defined to a lateral side of the first interior space, the third interior space containing at least one cooling unit or a heat exchanger;
   a first thermal barrier positioned between the first interior space and the second interior space; and
   a second thermal barrier positioned between the third interior space and the first interior space;
   wherein, in use:
      the at least one fan is configured to draw hot air from the first interior space into the second interior space across the first thermal barrier;
      the second interior space and the third interior space are fluidly coupled such that the hot air flows from the second interior space into the third interior space; and
      the at least one cooling unit is configured to condition the hot air in the third interior space to cold air and deliver the cold air into the first interior space across the second thermal barrier.
2. The data center according to clause 1, wherein the at least one fan and the at least one cooling unit are configured to recirculate air through the first, second, and third interior spaces, in sequence.
3. The data center according to clause 1 or 2, wherein:
   the first thermal barrier is a ceiling;
   the at least one fan is installed in the ceiling;
   the second thermal barrier is a wall; and
   the at least one cooling unit is disposed adjacent to the wall.
4. The data center according to any one of the preceding clauses, further comprising:
   at least one sensor disposed in the first interior space, the at least one sensor configured to sense at least one of air temperature or air pressure in the first interior space; and
   a controller communicatively coupled to the at least one fan and to the at least one sensor, the controller including processing circuitry configured to:
      receive at least one output from the at least one sensor; and
      independently control the at least one fan based on the received outputs from the at least one sensor.
5. The data center according to clause 4, wherein the controller is further communicatively coupled to the at least one cooling unit, and the processing circuitry is further configured to control the at least one cooling unit based on the received inputs from the at least one sensor.
6. The data center according to clause 4, wherein the at least one fan includes a plurality of fans defining at least one row of fans disposed overhead at least one row of electronic equipment disposed in the first interior space.
7. The data center according to any one of the preceding clauses, further comprising:
   at least one row of racks for mounting electronic equipment positioned in the first interior space; and
   at least one hot and cold aisle defined adjacent the at least one row of racks;
   wherein:
      the at least one fan is positioned above the at least one row of racks and is configured to draw the hot air from above the at least one row of racks; and
      the at least one cooling unit is configured to direct the cold air toward the at least one aisle.
8. A data center comprising:
   a first interior space for containing electronic equipment;
   a second interior space positioned to a lateral side of the first interior space, the second interior space containing at least one cooling unit;
   a third interior space positioned above the first interior space, the third interior space containing at least one fan;
   a first thermal barrier positioned between the first interior space and the second interior space; and
   a second thermal barrier positioned between the third interior space and the first interior space;
   wherein, in use:
      the at least one cooling unit is operable to draw hot air from the first interior space into the second interior space across the first thermal barrier, and condition the hot air to cold air;
      the second interior space and the third interior space are fluidly coupled such that the cold air flows from the second interior space into the third interior space; and
      the at least one fan is operable to deliver the cold air from the third interior space into the first interior space across the second thermal barrier..
9. The data center according to clause 8, wherein the at least cooling unit and the at least one fan are configured to recirculate air through the first, second, and third interior spaces, in sequence.
10. The data center according to clause 8 or 9, wherein:
   the first thermal barrier is a wall;
   the at least one cooling unit is positioned adjacent to the wall;
   the second thermal barrier is a ceiling; and
   the at least one fan is installed in the ceiling.
11. The data center according to any one of clauses 8-10, further comprising:
   at least one sensor positioned in the first interior space, the at least one sensor configured to sense at least one of air temperature or air pressure in the first interior space; and
   a controller communicatively coupled to the at least one fan and to the at least one sensor, the controller including processing circuitry configured to:
      receive at least one output from the at least one sensor; and
      independently control the at least one fan based on the received outputs from the at least one sensor.
12. The data center according to clause 11, wherein the controller is further communicatively coupled to the at least one cooling unit, and the processing circuitry is further configured to control the at least one cooling unit based on the received inputs from the at least one sensor.
13. The data center according to clause 11, wherein the at least one fan includes a plurality of fans forming at least one row of fans for positioning overhead at least one row of electronic equipment contained in the first interior space.
14. The data center according to any one of clauses 8-13, further comprising:
   at least one row of racks for mounting electronic equipment positioned in the first interior space; and
   at least one hot aisle and at least one cold aisle defined adjacent to the at least one row of racks;
   wherein:
      the at least one cooling unit is configured to draw the hot air from the at least one aisle; and
      the at least one fan is positioned above the at least one row of racks and is configured to direct the cold air toward the at least one row of racks.
15. A system for conditioning and recirculating air in a data center including electronic equipment positioned in an interior space, the system comprising:
   a first space positionable above the interior space, the first space containing at least one fan;
   a second space positionable to a lateral side of the interior space, the second space containing at least one cooling unit, and the second space fluidly coupled to the first space;
   at least one sensor positionable in the interior space, the at least one sensor configured to sense at least one of air temperature or air pressure in the interior space;
   a controller communicatively coupled to the at least one fan, to the at least one sensor, and to the at least one cooling unit, the controller including processing circuitry configured to:
      receive at least one output from the at least one sensor;
      independently control the at least one fan based on the received at least one output from the at least one sensor; and
      independently control the at least one cooling unit based on the received at least one output from the at least one sensor.
16. The system according to clause 15, wherein the controller is configured to:
   operate the at least one fan to draw hot air from the interior space into the first space;
   operate the at least one cooling unit to condition the hot air in the second space to cold air; and
   operate the at least one cooling unit to deliver the cold air into the interior space.
17. The system according to clause 16, wherein:
   the at least one fan is configured to draw hot air from above at least one rack of the electronic equipment; and
   the at least one cooling unit is configured to direct the cold air to at least one aisle positioned adjacent to the at least one rack of electronic equipment.
18. The system according to clause 15 or 16, wherein the controller is configured to:
   operate the at least one cooling unit to draw hot air from interior space, condition the hot air to cold air, and deliver the cold air into the second space; and
   operate the at least one fan to deliver the cold air in the first space to the interior space.
19. The system according to clause 18, wherein:
   the at least one cooling unit is configured to draw hot air from an aisle in the interior space; and
   the at least one fan is configured to direct the cold air toward at least one rack of electronic equipment positioned adjacent to the at least one aisle.
20. The system according to any one of clauses 15-19, wherein each of the first space and the second plenum is thermally separated from the interior space.

From the above description, it is clear that the present disclosure disclosed herein is well adapted to achieve the objectives and to attain the advantages mentioned herein as well as those inherent in the present disclosure disclosed herein. While exemplary examples of the present disclosure disclosed herein has been described for purposes of this disclosure, it will be understood that numerous changes may be made which will readily suggest themselves to those skilled in the art and which are accomplished within the broad scope and coverage of the present disclosure disclosed and claimed herein.

## Claims

1. A data center comprising:
a first interior space in which electronic equipment is disposed, the first interior space including at least one hot aisle and at least one cold separated according to a containment strategy;
a second interior space defined above the first interior space, the second interior space containing at least one fan;
a third interior space defined to a lateral side of the first interior space, the third interior space containing at least one cooling unit or a heat exchanger;
a first thermal barrier positioned between the first interior space and the second interior space; and
a second thermal barrier positioned between the third interior space and the first interior space;
wherein, in use:
the at least one fan is configured to draw hot air from the first interior space into the second interior space across the first thermal barrier;
the second interior space and the third interior space are fluidly coupled such that the hot air flows from the second interior space into the third interior space; and
the at least one cooling unit is configured to condition the hot air in the third interior space to cold air and deliver the cold air into the first interior space across the second thermal barrier.

2. The data center according to claim 1, wherein the at least one fan and the at least one cooling unit are configured to recirculate air through the first, second, and third interior spaces, in sequence.

3. The data center according to claim 1 or 2, wherein:
the first thermal barrier is a ceiling;
the at least one fan is installed in the ceiling;
the second thermal barrier is a wall; and
the at least one cooling unit is disposed adjacent to the wall.

4. The data center according to any one of the preceding claims, further comprising:
at least one sensor disposed in the first interior space, the at least one sensor configured to sense at least one of air temperature or air pressure in the first interior space; and
a controller communicatively coupled to the at least one fan and to the at least one sensor, the controller including processing circuitry configured to:
receive at least one output from the at least one sensor; and
independently control the at least one fan based on the received outputs from the at least one sensor.

5. The data center according to claim 4, wherein the controller is further communicatively coupled to the at least one cooling unit, and the processing circuitry is further configured to control the at least one cooling unit based on the received inputs from the at least one sensor.

6. The data center according to claim 4, wherein the at least one fan includes a plurality of fans defining at least one row of fans disposed overhead at least one row of electronic equipment disposed in the first interior space.

7. The data center according to any one of the preceding claims, further comprising:
at least one row of racks for mounting electronic equipment positioned in the first interior space; and
at least one hot and cold aisle defined adjacent the at least one row of racks;
wherein:
the at least one fan is positioned above the at least one row of racks and is configured to draw the hot air from above the at least one row of racks; and
the at least one cooling unit is configured to direct the cold air toward the at least one aisle.

8. A data center comprising:
a first interior space for containing electronic equipment;
a second interior space positioned to a lateral side of the first interior space, the second interior space containing at least one cooling unit;
a third interior space positioned above the first interior space, the third interior space containing at least one fan;
a first thermal barrier positioned between the first interior space and the second interior space; and
a second thermal barrier positioned between the third interior space and the first interior space;
wherein, in use:
the at least one cooling unit is operable to draw hot air from the first interior space into the second interior space across the first thermal barrier, and condition the hot air to cold air;
the second interior space and the third interior space are fluidly coupled such that the cold air flows from the second interior space into the third interior space; and
the at least one fan is operable to deliver the cold air from the third interior space into the first interior space across the second thermal barrier.

9. The data center according to claim 8, wherein the at least cooling unit and the at least one fan are configured to recirculate air through the first, second, and third interior spaces, in sequence; or optionally
wherein:
the first thermal barrier is a wall;
the at least one cooling unit is positioned adjacent to the wall;
the second thermal barrier is a ceiling; and
the at least one fan is installed in the ceiling.

10. The data center according to claim 8 or 9, further comprising:
at least one sensor positioned in the first interior space, the at least one sensor configured to sense at least one of air temperature or air pressure in the first interior space; and
a controller communicatively coupled to the at least one fan and to the at least one sensor, the controller including processing circuitry configured to:
receive at least one output from the at least one sensor; and
independently control the at least one fan based on the received outputs
from the at least one sensor; and optionally
wherein the controller is further communicatively coupled to the at least one cooling unit, and the processing circuitry is further configured to control the at least one cooling unit based on the received inputs from the at least one sensor.

11. The data center according to claim 10, wherein the at least one fan includes a plurality of fans forming at least one row of fans for positioning overhead at least one row of electronic equipment contained in the first interior space.

12. The data center according to any one of claims 8-11, further comprising:
at least one row of racks for mounting electronic equipment positioned in the first interior space; and
at least one hot aisle and at least one cold aisle defined adjacent to the at least one row of racks;
wherein:
the at least one cooling unit is configured to draw the hot air from the at least one aisle; and
the at least one fan is positioned above the at least one row of racks and is configured to direct the cold air toward the at least one row of racks.

13. A system for conditioning and recirculating air in a data center including electronic equipment positioned in an interior space, the system comprising:
a first space positionable above the interior space, the first space containing at least one fan;
a second space positionable to a lateral side of the interior space, the second space containing at least one cooling unit, and the second space fluidly coupled to the first space;
at least one sensor positionable in the interior space, the at least one sensor configured to sense at least one of air temperature or air pressure in the interior space;
a controller communicatively coupled to the at least one fan, to the at least one sensor, and to the at least one cooling unit, the controller including processing circuitry configured to:
receive at least one output from the at least one sensor;
independently control the at least one fan based on the received at least one output from the at least one sensor; and
independently control the at least one cooling unit based on the received at least one output from the at least one sensor.

14. The system according to claim 13, wherein the controller is configured to:
operate the at least one fan to draw hot air from the interior space into the first space;
operate the at least one cooling unit to condition the hot air in the second space to cold air; and
operate the at least one cooling unit to deliver the cold air into the interior space; and optionally wherein:
the at least one fan is configured to draw hot air from above at least one rack of the electronic equipment; and
the at least one cooling unit is configured to direct the cold air to at least one aisle positioned adjacent to the at least one rack of electronic equipment; or optionally
wherein each of the first space and the second plenum is thermally separated from the interior space.

15. The system according to claim 13 or claim 14, wherein the controller is configured to:
operate the at least one cooling unit to draw hot air from interior space, condition the hot air to cold air, and deliver the cold air into the second space; and
operate the at least one fan to deliver the cold air in the first space to the interior space; and optionally
wherein:
the at least one cooling unit is configured to draw hot air from an aisle in the interior space; and
the at least one fan is configured to direct the cold air toward at least one rack of electronic equipment positioned adjacent to the at least one aisle.
